# EUROPEAN PATENT APPLICATION

(11) **EP 4 761 557 A2**
(43) Date of publication of application: **17.06.2026**
(21) Application number: 25209443.8
(22) Date of filing: 17.10.2025
(51) Int. Cl.: H10W 10/17

(54) **TRENCH ISOLATION LINER FOR TRANSISTOR DEVICES**

(30) Priority: 16.12.2024 US 202418982591
(71) Applicant: Intel Corporation, Santa Clara, CA 95054 (US)
(72) Inventor: SAHA, Partha, Hillsboro, OR 97123 (US); GANAPATHY, Harish, Portland, OR 97229 (US); KHADILKAR, Aditi, King Of Prussia, PA 19406 (US); GU, Yuqian, Hillsboro, OR 97124 (US); BARADWAJ, Aditya, Portland, OR 97210 (US); GOPALAN, Devashish, Portland, OR 97229 (US); SINHA, Piyush, Portland, OR 97229 (US); JAMES, Robert, Portland, OR 97209 (US); JENSEN, Jacob, Beaverton, OR 97006 (US)
(74) Representative: HGF

(57) **Abstract**

In some embodiments, a trench isolation structure is formed from a first layer with enough carbon to sufficiently resist a dielectric etching process and a second, outer layer with surface wetting properties that allow it to adhere with the dielectric material that is to be etched.

## Description

### TECHNICAL FIELD

Embodiments of the invention relate to the field of semiconductor manufacturing; and more specifically, to the field of transistor fabrication.

### BRIEF DESCRIPTION OF THE DRAWINGS

The disclosure may best be understood by referring to the following description and accompanying drawings that are used to illustrate embodiments of the invention. In the drawings:
Fig. 1 is an exemplary perspective view of a gate all around (GAA) transistor.
Fig. 2 is a cross-sectional schematic view of adjacent transistor devices in a semiconductor wafer in accordance with some embodiments.
Figs. 3A and 3B show portions of adjacent devices with contact defects attributable to flawed trench isolation fabrication processes.
Fig. 4 is a flow diagram showing a routine 400 for making a trench isolation structure in accordance with some embodiments.
Figs. 5A-5G are cross-sectional schematic views of a trench isolation structure in various process formation stages in accordance with some embodiments.
Fig. 6 illustrates an example computing system in accordance with some embodiments.

### DETAILED DESCRIPTION

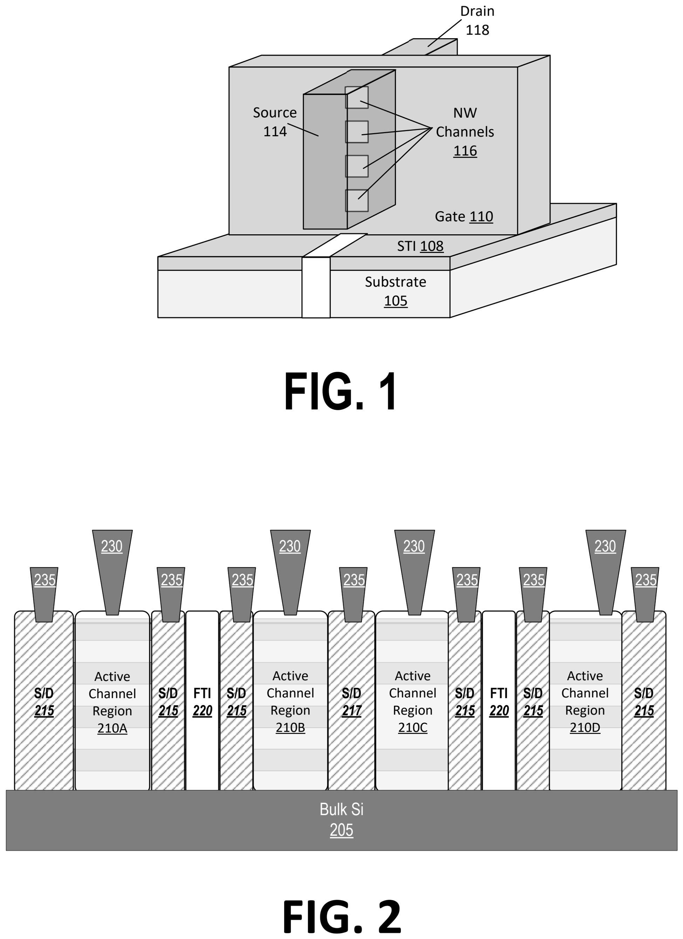

Fig. 1 is a schematic perspective view of a gate all around (GAA) transistor. The transistor is formed atop a wafer (or substrate) 105 and includes nanowire channels 116 that are surrounded by a gate structure 110 sitting on a shallow trench isolation (STI) layer 108. It also has a source 114 and a drain 118 that extend from the sides of the channels 116 as is shown.

As shown in the figure, GAA transistors feature a structure where the gate surrounds the channel on all sides, using stacked nanosheets (also referred to as nanowires, ribbons or simply nano channels). As compared with prior transistor designs, GAA transistors with their 360-degree gate coverage provide improved electrostatic control over the nano channels, reducing leakage currents and improving energy efficiency. They offer enhanced performance, allowing for higher drive currents and faster switching speeds. Moreover, their structural architectures enable continued transistor scaling to smaller dimensions, supporting the advancement of semiconductor technology.

Fig. 2 is a cross-sectional schematic view of adjacent transistor devices in a semiconductor wafer in accordance with some embodiments. The transistors are three-dimensional devices (e.g., FinFET or GAA transistors) with gate/channel regions 210 and source/drain (S/D) structures 215, 217, which may be formed from epitaxial growth extensions off of the sides of the gate/channel structures 210. There are also transistor contacts including gate contacts (GCN) 230 and trench contacts (TCN) 235. The gate contacts 230 are coupled to the gate structures, while the trench contacts 235 are coupled to the S/D structures.

Fig. 2 is an illustrative view showing, among other things, how with some implementations, adjacent transistor devices may be isolated from, or coupled with, adjacent devices. With the depicted example, devices 210A, 210D, and 210E have source/drain structures 215 separated from those of adjacent devices using isolation trench dielectric structures (e.g., fin trench isolation, FTI) structures 220. On the other hand, devices 210B/210C share a common source/drain region 217. This may be suitable, for example, with neighboring complementary P and N type devices implementing a circuit such as a P/N inverter.

Reliably fabricating trench isolation structures can be challenging. It is not only important that the trench isolation structure provides adequate physical characteristics (e.g., sufficient resistivity, S/D stress properties, etc.) in a small enough space, but also, it should be able to be reliably made without causing defects in neighboring transistor features.

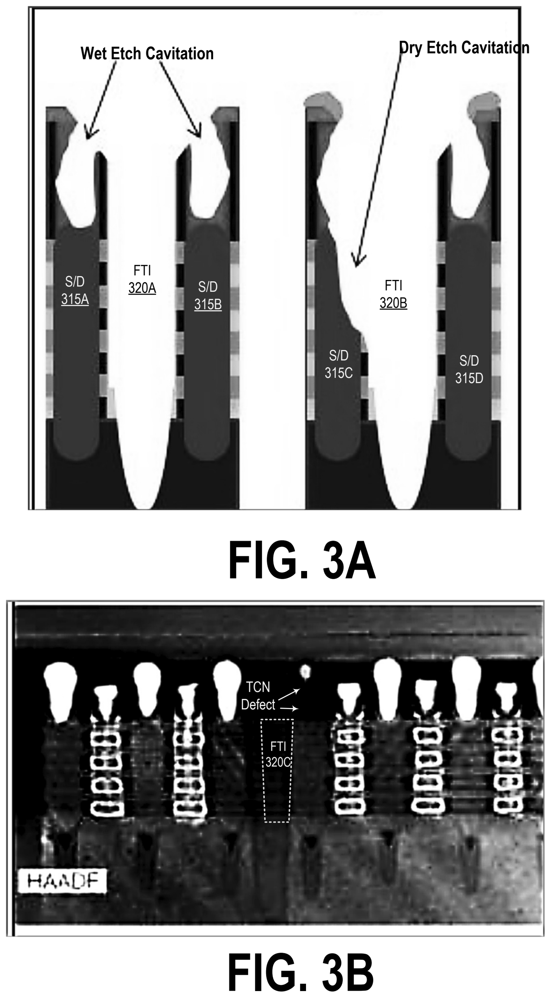

Figs. 3A and 3B show portions of adjacent devices with contact defects attributable to flawed trench isolation fabrication processes. Fig. 3A shows a first pair of adjacent S/D structures (315A, 315B) separated by FTI structure 320A. A wet etch process was used to trim a lower oxide dielectric layer in the FTI, but it penetrated through an underlying FTI liner, making cavities into the S/D epitaxial structure (or at least into a lower oxide layer atop the S/D structures. Fig. 3A also shows a second pair of adjacent S/D structures (315C, 315D) with similar problematic cavitation but from a dry etch process.

In both cases, the cavities cause defective TCN contacts for the affected S/D structures. This is illustrated in Fig. 3B, which is an image generated from an electron microscope. With this example, an FTI trench 320C was formed between adjacent S/D structures. A cavity defect had been etched through the utilized trench liner and into the upper surface of the S/D structure on the right-side of the FTI trench. This resulted in nitride dielectric material filling the cavity and subsequently blocking the TCN that was to be formed into and connected with the underlying S/D structure. (The nitride dielectric material was deposited as part of the dielectric used to fill the FTI trench.)

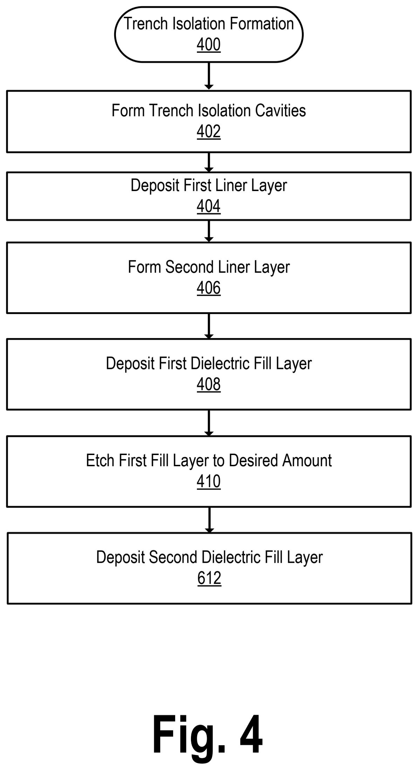

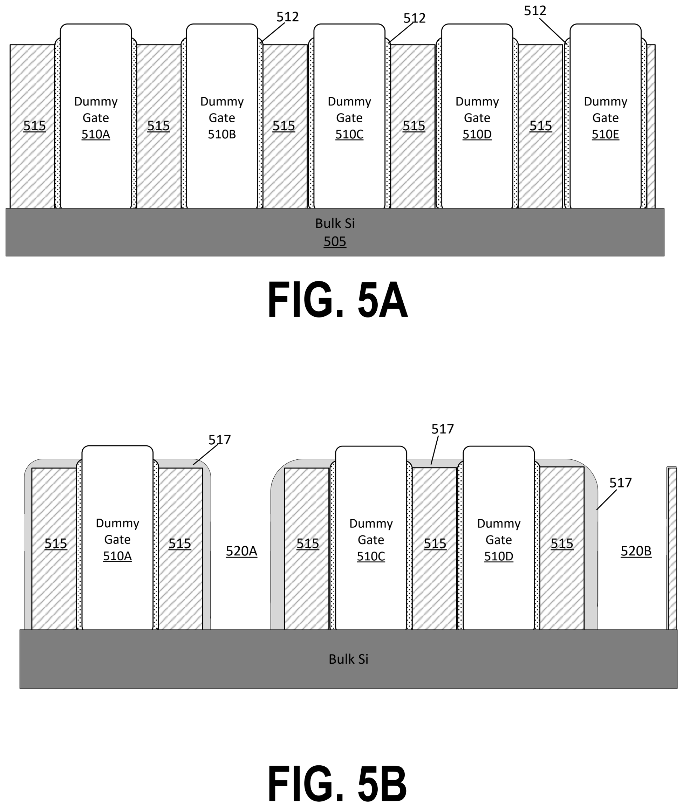

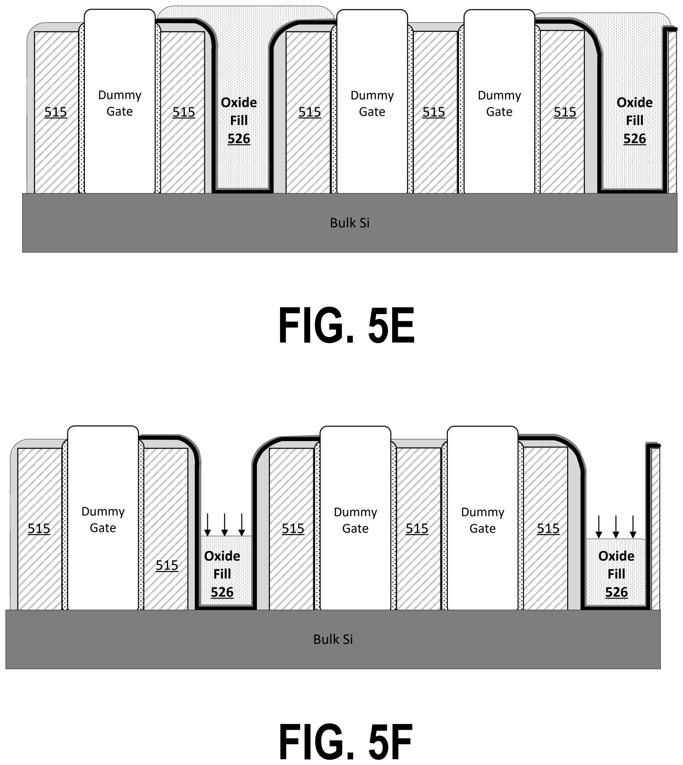

With simultaneous reference to Figs. 4 and 5A-5G, a process is illustrated for making trench isolation structures using a trench liner in accordance with some embodiments. Fig. 4 is a flow diagram showing a routine 400 for making a trench isolation structure, and Figs. 5A-5G are cross-sectional schematic views of the FTI structure in various process formation stages.

Ideally, a trench isolation liner, e.g., for NMOS devices, should be sufficiently thin, e.g., up to 75 A, to facilitate desired tensile properties and to accommodate a suitable amount of dielectric fill. It should also have adequate surface wetting (e.g., for acceptable oxide adhesion) to receive and attach with a flowable oxide dielectric fill material, and it should have a relatively high hermeticity and etch (e.g., wet-etch) resistance to prevent problematic etch defects. Accordingly, in some embodiments, a multilayer liner is provided that includes a first (e.g., underlying) carbon rich bulk layer with good etch resistance and a thinner second (e.g., outer) layer having good wetting and oxide retention properties. The first layer, with its larger amount of carbon, provides good etch resistance such as against wet etching processes used for removing oxides. However, it also has poor flowable dielectric adhesion characteristics. Accordingly, the second (outer layer) is formed on the lower carbon rich layer because it does have good surface wetting properties even though on its own, it would provide little etch resistance. Together, the two layers provide etch resistance and favorable dielectric adhesion.

In some embodiments, the second layer may be formed with surface treatments, for example, either ex-situ or in-situ to produce oxygen or hydroxyl surface termination. Other approaches may be used such as with thin film (e.g., monolayer) deposition to achieve suitable contact angle and surface wetting properties. With a liner formed using these first and second layers, a thin etch resistant bulk liner with a surface that promotes dielectric adhesion may be achieved. Below, a method to crate such a multi-layer liner is discussed.

Fig. 5A shows a cross-sectional view of a portion of adjacent transistor devices in a semiconductor wafer within a fabrication process. This view shows devices at a stage in the process where dummy gates such as poly-silicon gates (PSGs), along with epitaxial S/D structures 515 have been formed. Among other things, the dummy gate structures include within them one or more channel (e.g., Si) layers sandwiched between sacrificial layers of a material such as SiGe. Also shown are inner wall spacers 512 used as a boundary barrier from the dummy gate structures when the epitaxial S/D structures are formed.

With reference to Figs. 4 and 5B, at 402, trench cavities are formed from selected ones of the dummy gate structure spaces. With this example, dummy gates 510B and 510E are removed to form trenches 520A, 520B. The removal of polysilicon dummy gates prior to channel release processes involving replacement gate technologies may be performed in a variety of different ways including wet etch, dry etch and hybrid etch methods. Wet etch methods such as with tetra-methyl ammonium hydroxide (TMAH) are commonly used for wet etching of dummy polysilicon. This method allows for selective removal of the polysilicon while minimizing damage to the underlying materials. Dry etching such as plasma-based dry etching is another prevalent method. This approach utilizes reactive gases to selectively etch the polysilicon dummy gate while preserving the integrity of adjacent structures. The dry etching process can be finely tuned to optimize removal rates and selectivity. Hybrid methods combining both dry and wet etching techniques may also be used, leveraging efficiency and control advantages of both methods.

It should be appreciated that the trenches may be formed in any suitable manner. For example, they may be formed by removing (e.g., etching) material used in the dummy gate/channel layer structures. Alternatively, in some embodiments, they may be formed prior to dummy gate structure formation, with the trench regions formed, for example, by depositing sacrificial layer material at the trench isolation regions using a suitable lithographic process. For example, using photolithography and anisotropic etching techniques, trenches may be etched into the substrate between the fins. This etching process typically employs reactive ion etching to achieve high precision and control over the trench dimensions, which are designed to have a relatively high aspect ratio (depth-to-width ratio). Alternatively, they may be made from place-holder structures other than actual dummy gate structures used for active device gate/channels.

Fig. 5B shows the devices with formed trenches 520. Also shown is an oxide layer 517 formed atop the S/D structure surfaces, which may or may not also be atop the remaining dummy gate structures 510. (For convenience, deposited material layers, where not necessarily relevant, may not be shown, even though they may be present in some implementations.)

After source/drain epitaxial (epi) formation, an oxide layer may be formed as a result of the type of epi growth itself. For example, when the epi structures are made musing a chemical vapor deposition (CVD) process, the environment can lead to the formation of silicon oxide layers. This can occur through different mechanisms including thermal oxidation when the epi is exposed to oxygen at high temperatures and from chemical reactions where the use of oxygen-containing gases during etching or cleaning steps may also contribute to oxide formation on the source/drain regions. After the epi process, additional steps such as etching or chemical mechanical polishing (CMP) may expose underlying silicon or other materials to atmospheric conditions, leading to further oxidation.

At 404, a first liner layer is deposited into at around the trenches 520 using an atomic layer deposition (ALD) process such as a thermal ALD process. Thermal atomic layer deposition (ALD) is a thin-film deposition technique that allows for the precise control of material growth at the atomic level. In some embodiments, a thermal ALD process uses a series of cycles where a substrate is alternately exposed to two or more but typically two different gaseous precursors. Each precursor reacts with the substrate surface in a self-limiting manner with the reaction being inhibited once available reactive sites on the surface are filled. After each precursor exposure, an inert gas purge step may be performed to remove any unreacted precursors and by-products from the chamber before introducing the next precursor.

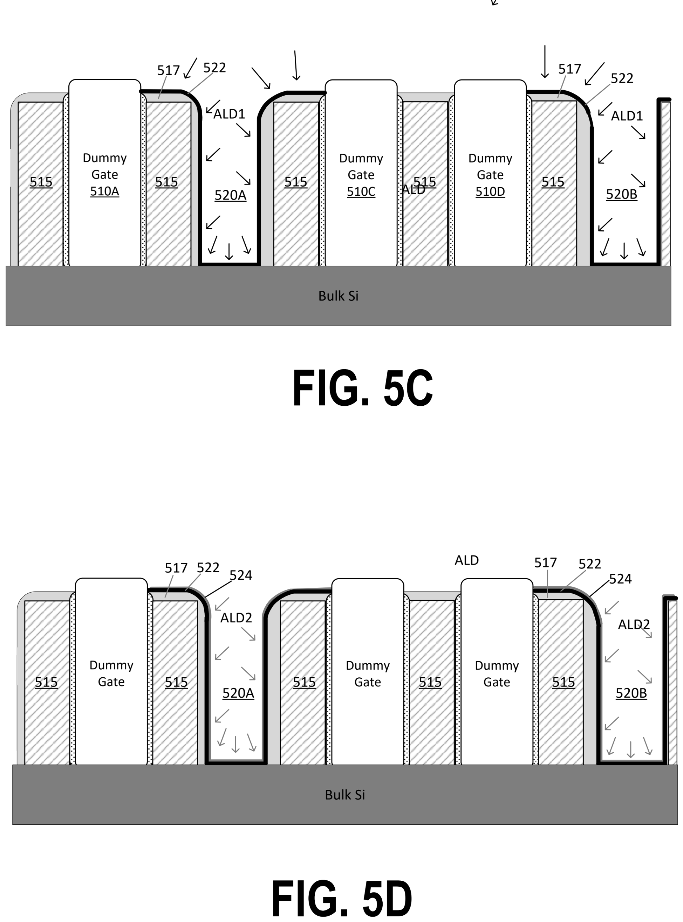

Fig. 5C shows the first liner layer at 522. In some embodiments, to form this layer, one or more alternating constituent precursor sub-layers are applied using thermal ALD until a desired thickness, e.g., 20-60 A, is attained. The alternating ALD precursor sub-layers may be implemented with silicon and/or nitrogen precursors such as silicon nitrides, silicon-oxynitrides, silicon-carbon-nitrides, and/or silicon-oxy-carbon-nitrides, to mention just a few. The nitride liners may be implemented with oxygen and carbon doped Silicon nitrides. The atomic percentage of oxygen and carbon can vary from 0 to 50% (meaning the film can vary from oxygen, carbon doped silicon nitride to primarily silicon carbide or silicon oxide), although a sufficient amount of carbon, e.g., 2 or higher carbon to oxygen ratio, may be implemented to adequately resist etching. In some embodiments, silicon precursors such as chlorosilane/aminosilane may be employed. Some examples are Bis(tert-butylamino)silane, octachlorotrisilane, dichlorosilane, tetrachlorosilane, hexachlorodisilane, and tris(dimethylamino) silane. Ideally, one or more of the atomically deposited sub-layers will include enough carbon (e.g., up to 50% by molecular portion) to effectively resist damaging oxide etching later to be applied when trimming the trench isolation oxide fill material. In some embodiments, the first layer film may be grown in a temperature range of 300-700 C and at a pressure in the range of 1 mTorr to 760 Torr.

At 406, the second liner layer (a thinner surface layer) is formed on the first liner layer. This is represented at Fig. 5D where the liner is shown with a first layer 522 and a second layer 524. The second layer may be thinner (e.g., 0 to 10 A) than the first layer and be made to have an oxygen and/or hydroxyl rich surface, which enables favorable surface wetting characteristics. For example, it may be formed from surface treatments that can be either ex-situ or in-situ to produce oxygen or hydroxyl surface termination. For example, ex-situ methods such as plasma or wet chemistry treatments or in-situ monolayer growth termination treatments may be used. In some embodiments, thin film (e.g., monolayer) deposition such as an ALD process may also or alternatively be used to achieve favorable contact angle and surface wetting properties in the second (outer) layer. The overall resulting liner is a thin etch resistant bulk liner with a surface that can promote dielectric adhesion.

At 408, a first trench isolation dielectric fill layer 526 is deposited. For example, with a trench liner having an oxygen or hydroxyl rich outer surface, a silicon oxide (e.g., silicon dioxide fill) may be used for the first dielectric layer. In some embodiments, the dielectric may be deposited using a dielectric material, e.g., high-density plasma (HDP) oxide. This can be done through various deposition methods, including chemical vapor deposition (CVD) or thermal oxidation.

Next, at 410 (Figs. 4 and 5F), the first fill layer is etched to a desired level. For example, epitaxial and channel strain properties can be tuned based on the amounts of the first dielectric layer and the second layer to be deposited.

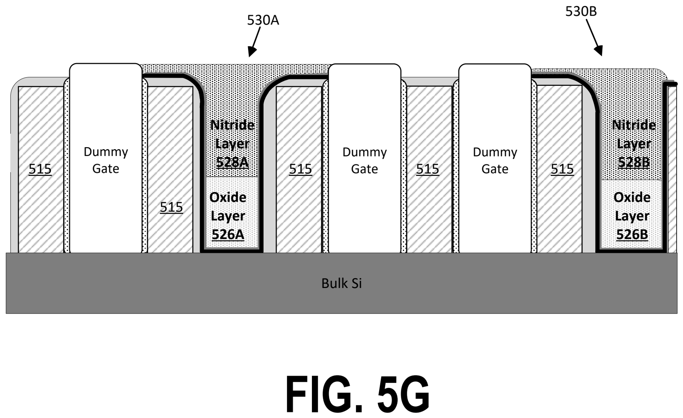

At 412 (and Fig. 5G), a second trench dielectric layer 528 is deposited atop the first trench isolation dielectric layer 526. In some embodiments, a nitride such as a silicon nitride dielectric fill material may be used. For example, silicon nitride may be deposited over the underlying dielectric (e.g., oxide) layer. This nitride layer acts as a barrier to oxygen diffusion and it can provide additional benefits such as reduced stress and improved corner rounding within the trench, which can minimize void formation during any subsequent filling.

From here, the surface may then be planarized, e.g., using chemical-mechanical polishing (CMP) to provide a flat surface for subsequent processing steps.

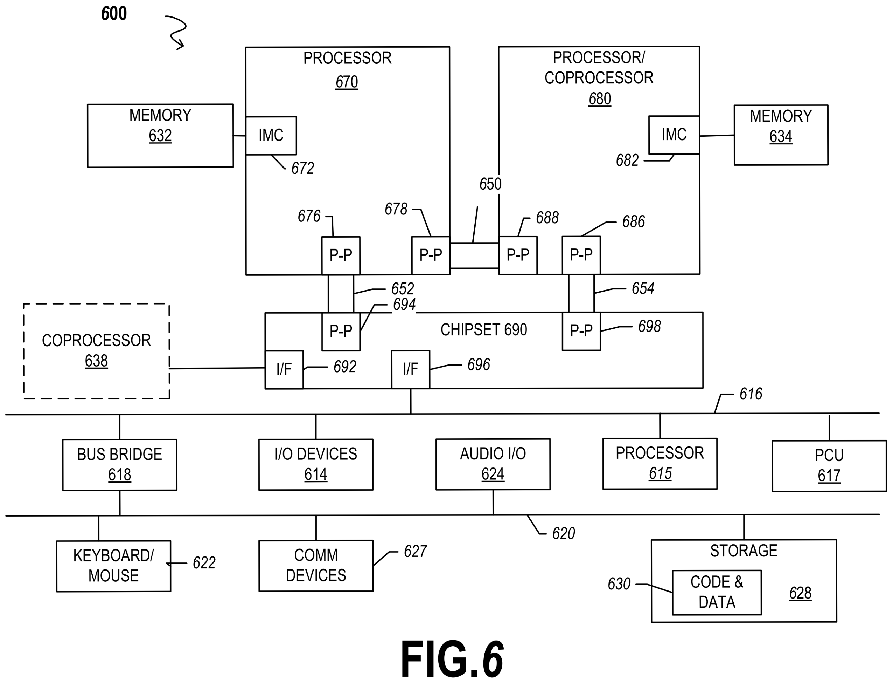

Fig. 6 illustrates an example computing system in accordance with some embodiments. Multiprocessor system 600 is an interfaced system and includes a plurality of processors including a first processor 670 and a second processor 680 coupled via an interface 650 such as a point-to-point (P-P) interconnect, a fabric, and/or bus. At least some of the integrated circuit dies used to implement the processors and/or other blocks in the depicted system include at least some transistors separated with trench isolation structures as discussed herein. In some examples, the first processor 670 and the second processor 680 are homogeneous. In some examples, first processor 670 and the second processor 680 are heterogenous. Though the example system 600 is shown to have two processors, the system may have three or more processors, or may be a single processor system. In some examples, the computing system is implemented, wholly or partially, with a system on a chip (SoC) or a multi-chip (or multi-chiplet) module, in the same or in different package combinations.

Processors 670 and 680 are shown including integrated memory controller (IMC) circuitry 672 and 682, respectively. Processor 670 also includes interface circuits 676 and 678, along with core sets. Similarly, second processor 680 includes interface circuits 686 and 688, along with a core set as well. A core set generally refers to one or more compute cores that may or may not be grouped into different clusters, hierarchal groups, or groups of common core types. Cores may be configured differently for performing different functions and/or instructions at different performance and/or power levels. The processors may also include other blocks such as memory and other processing unit engines.

Processors 670, 680 may exchange information via the interface 650 using interface circuits 678, 688. IMCs 672 and 682 couple the processors 670, 680 to respective memories, namely a memory 632 and a memory 634, which may be portions of main memory locally attached to the respective processors.

Processors 670, 680 may each exchange information with a network interface (NW I/F) 690 via individual interfaces 652, 654 using interface circuits 676, 694, 686, 698. The network interface 690 (e.g., one or more of an interconnect, bus, and/or fabric, and in some examples is a chipset) may optionally exchange information with a coprocessor 638 via an interface circuit 692. In some examples, the coprocessor 638 is a special-purpose processor, such as, for example, a high-throughput processor, a network or communication processor, compression engine, graphics processor, general purpose graphics processing unit (GPGPU), neural-network processing unit (NPU), embedded processor, or the like.

A shared cache (not shown) may be included in either processor 670, 680 or outside of both processors, yet connected with the processors via an interface such as P-P interconnect, such that either or both processors' local cache information may be stored in the shared cache if a processor is placed into a low power mode.

Network interface 690 may be coupled to a first interface 616 via interface circuit 696. In some examples, first interface 616 may be an interface such as a Peripheral Component Interconnect (PCI) interconnect, a PCI Express interconnect, or another I/O interconnect. In some examples, first interface 616 is coupled to a power control unit (PCU) 617, which may include circuitry, software, and/or firmware to perform power management operations with regard to the processors 670, 680 and/or co-processor 638. PCU 617 provides control information to one or more voltage regulators (not shown) to cause the voltage regulator(s) to generate the appropriate regulated voltage(s). PCU 617 also provides control information to control the operating voltage generated. In various examples, PCU 617 may include a variety of power management logic units (circuitry) to perform hardware-based power management. Such power management may be wholly processor controlled (e.g., by various processor hardware, and which may be triggered by workload and/or power, thermal or other processor constraints) and/or the power management may be performed responsive to external sources (such as a platform or power management source or system software).

PCU 617 is illustrated as being present as logic separate from the processor 670 and/or processor 680. In other cases, PCU 617 may execute on a given one or more of cores (not shown) of processor 670 or 680. In some cases, PCU 617 may be implemented as a microcontroller (dedicated or general-purpose) or other control logic configured to execute its own dedicated power management code, sometimes referred to as P-code. In yet other examples, power management operations to be performed by PCU 617 may be implemented externally to a processor, such as by way of a separate power management integrated circuit (PMIC) or another component external to the processor. In yet other examples, power management operations to be performed by PCU 617 may be implemented within BIOS or other system software. Along these lines, power management may be performed in concert with other power control units implemented autonomously or semi-autonomously, e.g., as controllers or executing software in cores, clusters, IP blocks and/or in other parts of the overall system.

Various I/O devices 614 may be coupled to first interface 616, along with a bus bridge 618 which couples first interface 616 to a second interface 620. In some examples, one or more additional processor(s) 615, such as coprocessors, high throughput many integrated core (MIC) processors, GPGPUs, accelerators (such as graphics accelerators or digital signal processing (DSP) units), field programmable gate arrays (FPGAs), or any other processor, are coupled to first interface 616. In some examples, second interface 620 may be a low pin count (LPC) interface. Various devices may be coupled to second interface 620 including, for example, a keyboard and/or mouse 622, communication devices 627 and storage circuitry 628. Storage circuitry 628 may be one or more non-transitory machine-readable storage media as described below, such as a disk drive or other mass storage device which may include instructions/code and data 630 and may implement the storage in some examples. Further, an audio I/O 624 may be coupled to second interface 620. Note that other architectures than the point-to-point architecture described above are possible. For example, instead of the point-to-point architecture, a system such as multiprocessor system 600 may implement a multi-drop interface or other such architecture.

Processor cores may be implemented in different ways, for different purposes, and in different processors. For instance, implementations of such cores may include: 1) a general purpose in-order core intended for general-purpose computing; 2) a high-performance general purpose out-of-order core intended for general-purpose computing; 3) a special purpose core intended primarily for graphics and/or scientific (throughput) computing. Implementations of different processors may include: 1) a CPU including one or more general purpose in-order cores intended for general-purpose computing and/or one or more general purpose out-of-order cores intended for general-purpose computing; and 2) a coprocessor including one or more special purpose cores intended primarily for graphics and/or scientific (throughput) computing. Such different processors lead to different computer system architectures, which may include: 1) the coprocessor on a separate chip from the CPU; 2) the coprocessor on a separate die in the same package as a CPU; 3) the coprocessor on the same die as a CPU (in which case, such a coprocessor is sometimes referred to as special purpose logic, such as integrated graphics and/or scientific (throughput) logic, or as special purpose cores); and 4) a system on a chip (SoC) that may be included on the same die as the described CPU (sometimes referred to as the application core(s) or application processor(s)), the above described coprocessor, and additional functionality. Example core architectures are described next, followed by descriptions of example processors and computer architectures.

Illustrative examples of the technologies disclosed herein are provided below. An embodiment of the technologies may include any one or more, and any compatible combination of, the examples described below.

Example 1 is an apparatus that includes a first plurality of transistor devices and a second plurality of trench isolation structures. The second plurality of trench isolation structures are each disposed between at least some adjacent ones of the first plurality of transistor devices. The trench isolation structures include:
a liner including a first liner layer portion including carbon to resist a first etching process and a second liner layer with a surface to adhere with a first dielectric fill layer that is sandwiched between the second liner layer and a second dielectric fill layer.

Example 2 includes the subject matter of example 1, and wherein the first liner layer is formed from a silicon material having carbon and oxygen, wherein a carbon to oxygen ratio for the material is at least 2.

Example 3 includes the subject matter of any of examples 1-2, and wherein the material includes one or more silicon nitride mono sub-layers including the carbon.

Example 4 includes the subject matter of any of examples 1-3, and wherein the second liner layer is formed from treating the first liner layer to have a surface with oxygen termination.

Example 5 includes the subject matter of any of examples 1-4, and wherein the second liner layer is formed from treating the first liner layer to have a surface with hydroxyl termination.

Example 6 includes the subject matter of any of examples 1-5, and wherein the first dielectric fill layer includes a silicon oxide material.

Example 7 includes the subject matter of any of examples 1-6, and wherein the second dielectric fill layer includes a silicon nitride material.

Example 8 includes the subject matter of any of examples 1-7, and wherein the transistor devices include N-type metal oxide semiconductor gate-all-around transistors.

Example 9 is a method. The method includes in a trench isolation cavity, depositing a first liner layer. It also includes forming a second liner layer at a surface of the first liner layer. It also includes depositing on the second liner layer a first dielectric fill layer. It further includes etching away at least some of the first dielectric fill layer, and depositing a second dielectric fill layer onto a remaining portion of the first dielectric fill layer.

Example 10 includes the subject matter of example 9, and wherein the first liner layer has a higher etch resistivity to an oxide etching process than the second liner layer, which has a higher adhesion to an oxide than the first liner layer.

Example 11 includes the subject matter of any of examples 9-10, and wherein depositing the first liner layer includes depositing first and second precursors using a thermal atomic layer deposition process.

Example 12 includes the subject matter of any of examples 9-11, and wherein the first and second precursors include silicon and nitride precursors.

Example 13 includes the subject matter of any of examples 9-12, and wherein the first liner layer includes by molecular volume more carbon than oxygen.

Example 14 includes the subject matter of any of examples 9-13, and wherein the first liner layer includes carbon and oxygen, wherein the ratio of carbon to oxygen is greater than two.

Example 15 includes the subject matter of any of examples 9-14, and wherein the first dielectric fill layer is formed from a dielectric oxide material.

Example 16 includes the subject matter of any of examples 9-15, and wherein the second dielectric fill layer is formed from a dielectric nitride material.

Example 17 is an apparatus that includes a processor die and a memory die.

The memory die is coupled to the processor die. The processor die includes a first plurality of transistor devices and a second plurality of trench isolation structures that are each disposed between at least some adjacent ones of the first plurality of transistor devices. The trench isolation structures include a liner having a first liner layer portion including carbon to resist a first etching process and a second liner layer with a surface to adhere with a first dielectric fill layer that is sandwiched between the second liner layer and a second dielectric fill layer.

Example 18 includes the subject matter of example 17, and wherein the first liner layer is formed from a silicon material having carbon and oxygen, wherein a carbon to oxygen ratio for the material is at least 2.

Example 19 includes the subject matter of any of examples 17-18, and wherein the material includes one or more silicon nitride mono sub-layers including the carbon.

Example 20 includes the subject matter of any of examples 17-19, and wherein the second liner layer is formed from treating the first liner layer to have a surface with oxygen termination.

Example 21 includes the subject matter of any of examples 17-20, and wherein the second liner layer is formed from treating the first liner layer to have a surface with hydroxyl termination.

Example 22 includes the subject matter of any of examples 17-21, and wherein the first dielectric fill layer includes a silicon oxide material.

Example 23 includes the subject matter of any of examples 17-22, and wherein the second dielectric fill layer includes a silicon nitride material.

Example 24 includes the subject matter of any of examples 17-23, and wherein the transistor devices include N-type metal oxide semiconductor gate-all-around transistors.

Reference in the specification to "an embodiment," "one embodiment," "some embodiments," or "other embodiments" means that a particular feature, structure, or characteristic described in connection with the embodiments is included in at least some embodiments, but not necessarily all embodiments. The various appearances of "an embodiment," "one embodiment," or "some embodiments" are not necessarily all referring to the same embodiments. If the specification states a component, feature, structure, or characteristic "may," "might," or "could" be included, that particular component, feature, structure, or characteristic is not required to be included.

Throughout the specification, and in the claims, the term "connected" means a direct connection, such as electrical, mechanical, or magnetic connection between the things that are connected, without any intermediary devices.

The term "coupled" means a direct or indirect connection, such as a direct electrical, mechanical, or magnetic connection between the things that are connected or an indirect connection, through one or more passive or active intermediary devices.

The term "circuit" or "module" may refer to one or more passive and/or active components that are arranged to cooperate with one another to provide a desired function. It should be appreciated that different circuits or modules may consist of separate components, they may include both distinct and shared components, or they may consist of the same components. For example, A controller circuit may be a first circuit for performing a first function, and at the same time, it may be a second controller circuit for performing a second function, related or not related to the first function.

The meaning of "in" includes "in" and "on" unless expressly distinguished for a specific description.

The terms "substantially," "close," "approximately," "near," and "about," unless otherwise indicated, generally refer to being within +/-10% of a target value.

Unless otherwise specified, the use of the ordinal adjectives "first," "second," and "third," etc., to describe a common object, merely indicate that different instances of like objects are being referred to and are not intended to imply that the objects so described must be in a given sequence, either temporally, spatially, in ranking or in any other manner

For the purposes of the present disclosure, phrases "A and/or B" and "A or B" mean (A), (B), or (A and B). For the purposes of the present disclosure, the phrase "A, B, and/or C" means (A), (B), (C), (A and B), (A and C), (B and C), or (A, B and C).

It is pointed out that those elements of the figures having the same reference numbers (or names) as the elements of any other figure can operate or function in any manner similar to that described but are not limited to such.

For purposes of the embodiments, unless expressly described differently, the transistors in various circuits and logic blocks described herein may be implemented with any suitable transistor type such as field effect transistors (FETs) or bipolar type transistors. FET transistor types may include but are not limited to metal oxide semiconductor (MOS) type FETs such as tri-gate, FinFET, and gate all around (GAA) FET transistors, as well as tunneling FET (TFET) transistors, ferroelectric FET (FeFET) transistors, or other transistor device types including at least some transistors with trench isolation structures as described herein.

In addition, well-known power/ground connections to integrated circuit (IC) chips and other components may or may not be shown within the presented figures, for simplicity of illustration and discussion, and so as not to obscure the disclosure. Further, arrangements may be shown in block diagram form in order to avoid obscuring the disclosure, and also in view of the fact that specifics with respect to implementation of such block diagram arrangements are dependent Note that in the corresponding drawings of the embodiments, signals are represented with lines. Some lines may be thicker, to indicate a greater number of constituent signal paths, and/or have arrows at one or more ends, to indicate a direction of information flow. Such indications are not intended to be limiting. Rather, the lines are used in connection with one or more exemplary embodiments to facilitate easier understanding of a circuit or a logical unit. Any represented signal, as dictated by design needs or preferences, may actually comprise one or more signals that may travel in either direction and may be implemented with any suitable type of signal scheme upon the platform within which the present disclosure is to be implemented.

As defined herein, the term "if" means "when" or "upon" or "in response to" or "responsive to," depending upon the context. Thus, the phrase "if it is determined" or "if [a stated condition or event] is detected" may be construed to mean "upon determining" or "in response to determining" or "upon detecting [the stated condition or event]" or "in response to detecting [the stated condition or event]" or "responsive to detecting [the stated condition or event]" depending on the context. As defined herein, the term "responsive to" means responding or reacting readily to an action or event. Thus, if a second action is performed "responsive to" a first action, there is a causal relationship between an occurrence of the first action and an occurrence of the second action. The term "responsive to" indicates the causal relationship.

As defined herein, the term "processor" means at least one hardware circuit configured to carry out instructions contained in program code. The hardware circuit may be implemented with one or more integrated circuits. Examples of a processor include, but are not limited to, a central processing unit (CPU), an array processor, a vector processor, a digital signal processor (DSP), a field-programmable gate array (FPGA), a programmable logic array (PLA), an application specific integrated circuit (ASIC), programmable logic circuitry, a graphics processing unit (GPU), a controller, and so forth. It should be appreciated that a logical processor, on the other hand, is a processing abstraction associated with a core, for example when one or more SMT cores are being used such that multiple logical processors may be associated with a given core, for example, in the context of core thread assignment.

It should be appreciated that a processor or processor system may be implemented in various different manners. For example, it may be implemented on a single die, multiple dies (dielets, chiplets), one or more dies in a common package, or one or more dies in multiple packages. Along these lines, some of these blocks may be located separately on different dies or together on two or more different dies.

While the flow diagrams in the figures show a particular order of operations performed by certain embodiments of the invention, it should be understood that such order is exemplary (e.g., alternative embodiments may perform the operations in a different order, combine certain operations, overlap certain operations, etc.).

While the invention has been described in terms of several embodiments, those skilled in the art will recognize that the invention is not limited to the embodiments described, can be practiced with modification and alteration within the spirit and scope of the appended claims. The description is thus to be regarded as illustrative instead of limiting.

## Claims

1. An apparatus, comprising:
a first plurality of transistor devices; and
a second plurality of trench isolation structures disposed between at least some adjacent ones of the first plurality of transistor devices, wherein the trench isolation structures include:
a liner including a first liner layer portion including carbon to resist a first etching process and
a second liner layer with a surface to adhere with a first dielectric fill layer that is sandwiched between the second liner layer and a second dielectric fill layer.

2. The apparatus of claim 1, wherein the first liner layer is formed from a silicon material having carbon and oxygen, wherein a carbon to oxygen ratio for the material is at least 2.

3. The apparatus of claim 2, wherein the material includes one or more silicon nitride mono sub-layers including the carbon.

4. The apparatus of any of claims 1-3, wherein the second liner layer is formed from treating the first liner layer to have a surface with oxygen termination.

5. The apparatus of any of claims 1-4, wherein the second liner layer is formed from treating the first liner layer to have a surface with hydroxyl termination.

6. The apparatus of any of claims 1-5, wherein the first dielectric fill layer includes a silicon oxide material.

7. The apparatus of any of claims 1-6, wherein the second dielectric fill layer includes a silicon nitride material.

8. The apparatus of any of claims 1-7, wherein the transistor devices include N-type metal oxide semiconductor gate-all-around transistors.

9. A method, comprising:
in a trench isolation cavity, depositing a first liner layer;
forming a second liner layer at a surface of the first liner layer;
depositing on the second liner layer a first dielectric fill layer;
etching away at least some of the first dielectric fill layer; and
depositing a second dielectric fill layer onto a remaining portion of the first dielectric fill layer.

10. The method of claim 9, wherein the first liner layer has a higher etch resistivity to an oxide etching process than the second liner layer, which has a higher adhesion to an oxide than the first liner layer.

11. The method of any of claims 9-10, wherein depositing the first liner layer includes depositing first and second precursors using a thermal atomic layer deposition process.

12. The method of claim 11, wherein the first and second precursors include silicon and nitride precursors.

13. The method of any of claims 9-12, wherein the first liner layer includes by molecular volume more carbon than oxygen.

14. The method of claim 13, wherein the first liner layer includes carbon and oxygen, wherein the ratio of carbon to oxygen is greater than two.

15. The method of any of claims 9-14, wherein the first dielectric fill layer is formed from a dielectric oxide material.
